(19) Europäisches Patentamt
European Patent Office
Office européen des brevets

(11) **EP 4 535 247 A1**

(12) **EUROPEAN PATENT APPLICATION**
published in accordance with Art. 153(4) EPC

(43) Date of publication:
**09.04.2025 Bulletin 2025/15**

(21) Application number: **23834388.3**

(22) Date of filing: **03.03.2023**

(51) International Patent Classification (IPC):
**G06N 20/00** $^{(2019.01)}$ **G06F 30/20** $^{(2020.01)}$

(52) Cooperative Patent Classification (CPC):
**G06F 30/20; G06N 20/00**

(86) International application number:
**PCT/CN2023/079613**

(87) International publication number:
**WO 2024/007604 (11.01.2024 Gazette 2024/02)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 08.07.2022 CN 202210801101
10.11.2022 CN 202211405539

(71) Applicant: **Huawei Cloud Computing Technologies Co., Ltd.**
**Guiyang, Guizhou 550025 (CN)**

(72) Inventors:
• **LI, Jianshu**
**Guiyang, Guizhou 550025 (CN)**
• **YANG, Muming**
**Guiyang, Guizhou 550025 (CN)**
• **MAO, Kun**
**Guiyang, Guizhou 550025 (CN)**

(74) Representative: **Goddar, Heinz J. et al**
**Boehmert & Boehmert**
**Anwaltspartnerschaft mbB**
**Pettenkoferstrasse 22**
**80336 München (DE)**

(54) **MATHEMATICAL MODEL SOLVING METHOD AND APPARATUS, AND COMPUTING DEVICE AND COMPUTING DEVICE CLUSTER**

(57) A mathematical model solving method is disclosed, which may be applied to a computing device or a computing device cluster. The method may include: obtaining a problem description entered by a user, where the problem description includes a decision variable, a constraint, and an objective function; extracting a feature in the problem description by using a first artificial intelligence AI model, to obtain a first feature; processing the first feature to obtain target data, where the target data includes a target model obtained by optimizing the problem description based on the first feature and/or a solving approach generated based on the first feature; and calculating, based on the target data, a value of each decision variable that meets the constraint in the problem description, and outputting the value of each decision variable. In this way, during mathematical model solving, after the user provides the problem description, a corresponding decision can be obtained, thereby reducing dependence on user experience in a mathematical modeling step and a problem solving step, and improving efficiency and generalization of mathematical modeling and problem solving.

```
┌─────────────────────────────────────────────────────────────────┐
│ Obtain a problem description entered by a user, where the         │ S501
│ problem description includes a decision variable, a constraint    │
│ condition, and an objective function                              │
└─────────────────────────────────────────────────────────────────┘
                              │
                              ▼
┌─────────────────────────────────────────────────────────────────┐
│ Extract a feature in the problem description by using a first     │ S502
│ AI model, to obtain a first feature                               │
└─────────────────────────────────────────────────────────────────┘
                              │
                              ▼
┌─────────────────────────────────────────────────────────────────┐
│ Process the first feature to obtain target data, where the        │ S503
│ target data includes a target model obtained by optimizing the    │
│ problem description based on the first feature and/or a solving    │
│ approach generated based on the first feature                     │
└─────────────────────────────────────────────────────────────────┘
                              │
                              ▼
┌─────────────────────────────────────────────────────────────────┐
│ Calculate, based on the target data, a value of each decision     │ S504
│ variable that meets the constraint condition in the problem       │
│ description, and output the value of each decision variable       │
└─────────────────────────────────────────────────────────────────┘
```

FIG. 5

EP 4 535 247 A1

## Description

This application claims priority to Chinese Patent Application No. 202210801101.3, filed with the China National Intellectual Property Administration on July 8, 2022 and entitled "MODEL OPTIMIZING AND SOLVING SYSTEM", and to Chinese Patent Application No. 202211405539.6, filed with the China National Intellectual Property Administration on November 10, 2022 and entitled "MATHEMATICAL MODEL SOLVING METHOD AND APPARATUS, COMPUTING DEVICE, AND COMPUTING DEVICE CLUSTER", both of which are incorporated herein by reference in their entireties.

## TECHNICAL FIELD

This application relates to the field of artificial intelligence (artificial intelligence, AI) technologies, and in particular, to a mathematical model solving method and apparatus, a computing device, and a computing device cluster.

## BACKGROUND

Operational research mainly uses mathematical methods to study optimization approaches and solutions for various systems, to provide scientific decision basis for decision makers. Mathematical programming is an important branch of operational research, and a main research objective of the mathematical programming is to find an optimal solution that can minimize or maximize a function in a given area. The mathematical programming is widely applied, and the mathematical programming can be divided into a plurality of branches based on natures of problems and differences in processing methods, such as linear programming, integer programming, nonlinear programming, combination optimizing, multi-objective programming, random programming, dynamic programming, and parameter programming. Different mathematical programming methods may be applied to different scenarios. For example, the linear programming may be applied to a network flow optimization problem, and mixed integer programming may be applied to a production scheduling problem, a supply chain problem, a production dispatching problem, a factory site selection problem, and the like.

Two key steps are needed to solve practical application problems with operational research tools, namely, mathematical modeling and problem solving. The mathematical modeling (mathematical modeling) is to abstract a decision optimization problem in production and life as a mathematical programming problem. The mathematical programming problem generally includes three parts: a decision variable (decision variable), a constraint (constraint) and an objective function (objective function). The decision variable represents content that actually needs to be decided, for example, a quantity of commodities to be produced and manpower to be invested. The constraint represents a resource constraint encountered during decision making, for example, limited raw materials and funds. The objective function is an evaluation indicator of decision quality, for example, profit maximization and cost minimization. The problem solving (problem solving) is to select a specific solving approach to solve the mathematical programming problem, to obtain an optimal solution or a feasible solution of the problem, that is, a value of a decision variable that meets all constraints.

However, currently, user experience is highly depended on in both the mathematical modeling step and the problem solving step, for example, usually need participation of both experts in an industry and experts in the operational research to construct a mathematical model and a solving approach that are suitable for calculation. This greatly reduces efficiency of mathematical modeling and problem solving, and generalization of mathematical modeling and problem solving is poor (that is, only specific experts can perform mathematical modeling and formulate a solving approach). Therefore, how to improve efficiency of mathematical modeling and problem solving, and improve generalization of mathematical modeling and problem solving is currently an urgent technical problem to be resolved.

## SUMMARY

This application provides a mathematical model solving method and apparatus, a computing device, a computing device cluster, a computer storage medium, and a computer product, to improve efficiency of mathematical modeling and problem solving, and improve generalization of mathematical modeling and problem solving.

According to a first aspect, this application provides a mathematical model solving method, and the method may be applied to a computing device or a computing device cluster. The method may include: obtaining a problem description entered by a user, where the problem description includes a decision variable, a constraint, and an objective function; extracting a feature in the problem description by using a first artificial intelligence AI model, to obtain a first feature; processing the first feature to obtain target data, where the target data includes a target model obtained by optimizing the problem description based on the first feature and/or a solving approach generated based on the first feature; and calculating, based on the target data, a value of each decision variable that meets the constraint in the problem description, and outputting the value of each decision variable.

In this way, during mathematical model solving, after the user provides the problem description, a corresponding decision can be obtained, thereby reducing dependence on user experience in a mathematical modeling step and a problem solving step, and improving efficiency and generalization of mathematical modeling and problem solving.

In a possible implementation, the target data may be the target model. In this case, the calculating, based on the target data, a value of each decision variable that meets the constraint in the problem description may specifically include: inputting the target model into a preset solver (that is, a solver that is set previously), to obtain the value of each decision variable. The solver is software for solving a mathematical programming problem, and is widely used in fields such as cloud computing, finance, transportation, manufacturing, and energy.

In a possible implementation, the target data may be the solving approach. In this case, the calculating, based on the target data, a value of each decision variable that meets a constraint in the problem description may specifically include: reading, for calculation according to the solving approach, an original model obtained by processing the problem description by using a modeling tool, to obtain the value of each decision variable.

In a possible implementation, the target data may be the target model and the solving approach. In this case, the calculating, based on the target data, a value of each decision variable that meets the constraint in the problem description may specifically include: reading the target model for calculation according to the solving approach, to obtain the value of each decision variable.

In a possible implementation, the processing the first feature to obtain target data may specifically include: optimizing a quantity and/or an expression form of at least one of the decision variable, the constraint, and the objective function in the problem description by using a second AI model and the first feature, to obtain the target model; and/or

selecting N algorithms from an algorithm library by using a third AI model and the first feature, where N≥1, and orchestrating an execution sequence and/or a calling relationship of the N algorithms, to obtain the solving approach.

In a possible implementation, the method may further include: updating at least one of the first AI model, the second AI model, and the third AI model based on problem descriptions entered by different users. For example, an algorithm library, a model library, a feature library, or the like in a model may be updated based on duration for each solving, quality of a solution obtained through calculation, or the like. In this way, accuracy of extracting a feature of a problem description each time is improved, accuracy of model optimization is improved, or efficiency of a solving approach is improved.

In a possible implementation, the first feature may include at least one of a semantic feature, a structure feature, and a data feature. The semantic feature represents at least one of a name of each decision variable, a name of each constraint, a name of the objective function, and a name of a problem expressed by the problem description. The structure feature represents at least one of a structure of the coefficient matrix associated with the constraint, a distribution rule of a non-zero element in the coefficient matrix, and a type of each constraint. The data feature represents at least one of a value of each element in the coefficient matrix and a value of a constant term corresponding to each constraint.

In a possible implementation, the foregoing problem description may further include a solving preference of the user. In this case, the first feature may further include a user preference feature. The user preference feature may represent a requirement of the user for solving; and/or the foregoing problem description may further include background information of a problem that the user needs to solve. In this case, the first feature may further include a problem background feature. The problem background feature may represent a field or an industry to which the problem that the user needs to solve belongs.

According to a second aspect, this application provides a mathematical model solving apparatus. The apparatus may be deployed in a computing device or a computing device cluster. The apparatus may include an obtaining module and a processing module. The obtaining module may be configured to obtain a problem description entered by a user, where the problem description includes a decision variable, a constraint, and an objective function. The processing module may be configured to extract a feature in the problem description by using a first artificial intelligence AI model, to obtain a first feature. The processing module may be further configured to process the first feature to obtain target data, where the target data includes a target model obtained by optimizing the problem description based on the first feature and/or a solving approach generated based on the first feature. The processing module may be further configured to: calculate, based on the target data, a value of each decision variable that meets the constraint in the problem description, and output the value of each decision variable.

In a possible implementation, the target data is the target model. When calculating, based on the target data, the value of each decision variable that meets the constraint in the problem description, the processing module is specifically configured to input the target model into a preset solver, to obtain the value of each decision variable.

In a possible implementation, the target data is the solving approach. When calculating, based on the target data, the value of each decision variable that meets the constraint in the problem description, the processing module is specifically configured to: read, for calculation according to the solving approach, an original model obtained by processing the problem description by using a modeling tool, to obtain the value of each decision variable.

In a possible implementation, the target data is the target model and the solving approach. When calculating, based on the target data, the value of each decision variable that meets the constraint in the problem description, the processing module is specifically configured to read the target model for calculation according to the solving approach, to obtain the value of each decision variable.

In a possible implementation, when processing the first feature to obtain the target data, the processing module is specifically configured to optimize a quantity and/or an expression form of at least one of the decision variable, the constraint, and the objective function in the problem description by using a second AI model and the first feature, to obtain the target model; and/or select N algorithms from an algorithm library by using a third AI model and the first feature, where N≥1, and orchestrate an execution sequence and/or a calling relationship of the N algorithms, to obtain the solving approach.

In a possible implementation, the processing module is further configured to update at least one of the first AI model, the second AI model, and the third AI model based on problem descriptions entered by different users.

In a possible implementation, the first feature includes at least one of a semantic feature, a structure feature, or a data feature. The semantic feature represents at least one of a name of each decision variable, a name of each constraint, a name of the objective function, and a name of a problem expressed by the problem description. The structure feature represents at least one of a structure of a coefficient matrix associated with the constraint, a distribution rule of a non-zero element in the coefficient matrix, and a type of each constraint. The data feature represents at least one of a value of each element in the coefficient matrix and a value of a constant term corresponding to each constraint.

In a possible implementation, the problem description further includes a solving preference of the user, the first feature includes a user preference feature, and the user preference feature represents a requirement of the user for solving; and/or, the problem description further includes background information of a problem that the user needs to solve, the first feature includes a problem background feature, and the problem background feature represents a field or an industry to which the problem that the user needs to solve belongs.

In a possible implementation, the processing module is further configured to update the first AI model and/or the second AI model based on the problem descriptions entered by the different users.

According to a third aspect, this application provides a computing device, including at least one memory and at least one processor. The memory may be configured to store a program. The processor is configured to execute the program stored in the memory. When the program stored in the memory is executed, the processor is configured to perform the method described in any one of the first aspect or the possible implementations of the first aspect.

According to a fourth aspect, this application provides a computing device cluster, including at least one computing device. Each computing device includes a processor and a memory, and the processor of the at least one computing device is configured to execute instructions stored in the memory of the at least one computing device, so that the computing device cluster performs the method described in any one of the first aspect or the possible implementations of the first aspect.

According to a fifth aspect, this application provides a computer-readable storage medium. The computer-readable storage medium stores a computer program. When the computer program is run on a processor, the processor is enabled to perform the method described in any one of the first aspect or the possible implementations of the first aspect.

According to a sixth aspect, this application provides a computer program product. When the computer program product runs on a processor, the processor is enabled to perform the method described in any one of the first aspect or the possible implementations of the first aspect.

It may be understood that, for beneficial effects of the second aspect to the sixth aspect, refer to related descriptions in the first aspect. Details are not described herein again.

## BRIEF DESCRIPTION OF DRAWINGS

The following briefly describes accompanying drawings that need to be used in descriptions of embodiments or the conventional technology.

FIG. 1 is a diagram of a process of mathematical modeling and problem solving according to an embodiment of this application;

FIG. 2 is a diagram of a form of interaction between a user and a mathematical model solving platform according to an embodiment of this application;

FIG. 3 is a diagram of an architecture of a mathematical model solving platform according to an embodiment of this application;

FIG. 4 is a diagram of a structure of a coefficient matrix according to an embodiment of this application;

FIG. 5 is a schematic flowchart of a mathematical solving method according to an embodiment of this application;

FIG. 6 is a diagram of a structure of a mathematical solving apparatus according to an embodiment of this application;

FIG. 7 is a diagram of a structure of a computing device according to an embodiment of this application; and

FIG. 8 is a diagram of a structure of a computing device cluster according to an embodiment of this application.

## DESCRIPTION OF EMBODIMENTS

The term "and/or" in this specification describes an association relationship between associated objects and represents that three relationships may exist. For example, A and/or B may represent the following three cases: Only A exists, both A and B exist, and only B exists. The character "/" in this specification indicates an "or" relationship between the associated objects. For example, A/B indicates A or B.

In the specification and claims of this application, the terms "first", "second", and the like are intended to distinguish between different objects, but do not indicate a particular order of the objects. For example, a first response message, a second response message, and the like are used to distinguish between different response messages, but do not indicate a particular order of the response messages.

In embodiments of this application, the term "example" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the term "example", "for example", or the like is intended to present a related concept in a specific manner.

In the descriptions of embodiments of this application, unless otherwise specified, "a plurality of" means two or more. For example, a plurality of processing units are two or more processing units, and a plurality of elements are two or more elements.

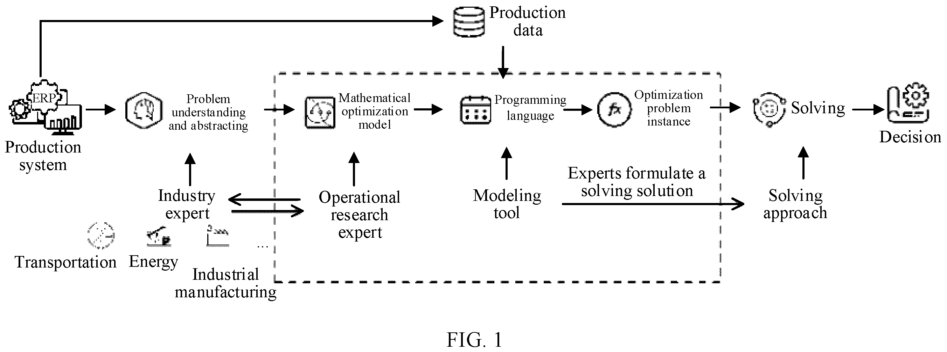

For example, FIG. 1 shows a process of mathematical modeling and problem solving. As shown in FIG. 1, when a production system needs to be optimized, experts in an industry (such as transportation, energy, and industrial manufacturing) and experts in operational research may cooperate to understand and abstract a problem to be optimized, and construct a corresponding mathematical optimization model. Then, the mathematical optimization model and production data in the production system may be processed by using a modeling tool (mathematical programming modeling tools) to obtain an instance of a mathematical optimization problem. Then, the operational research expert can manually formulate a solving approach. Finally, the instance of the mathematical optimization problem may be solved according to the solving approach, to obtain a needed decision. It can be seen that, both in a mathematical modeling step and a problem solving step, participation of industry experts and operational research experts is needed.

In the mathematical modeling step, a modeler needs to be familiar with a service background and understand meaning and requirements of each decision factor; and the modeler further needs to have considerable mathematical optimization skills and can convert variables and constraints of different types of decisions into corresponding mathematical relationships, to form a complete mathematical programming problem. In addition, there are good and bad mathematical optimization models. A "good" model is easy to solve or not easy to cause numerical precision problems. A "bad" model is not easy to solve or easy to cause numerical precision problems. There are usually a plurality of equivalent modeling methods for a same problem. A modeler needs to have long-term academic training to master a skill of building a "good" model.

In the problem solving step, complex multiphase decision-making optimization problems are usually encountered in actual production, and a single standard solver cannot meet the problem solving requirement. A user needs to develop a customized algorithm and perform integrating and orchestrating by using an existing solving tool to form a complete solving approach. To formulate a solving approach, a deep understanding of a nature of a problem, and mastering of designs and usage skills of various solvers and solving algorithms are needed. Therefore, an experienced operational research expert is usually needed.

It can be seen that, user experience is highly depended on in both the mathematical modeling step and the problem solving step.

In view of this, embodiments of this application provide a mathematical model solving method, so that after a user enters, through an interface, a command line, or the like, a problem description including a decision variable, a constraint, an objective function, and the like, a feature extraction may be performed on the problem description. Then, the problem description may be optimized and/or a solving approach may be generated based on an extracted feature by using an AI model. Finally, a value of each decision variable that meets the constraint in the problem description may be calculated by using an optimized model and/or a generated solving approach, to obtain the needed value of each decision variable. In this way, after the user provides the problem description, a corresponding decision can be obtained, thereby reducing dependence on user experience in a mathematical modeling step and a problem solving step, and improving efficiency and generalization of mathematical modeling and problem solving.

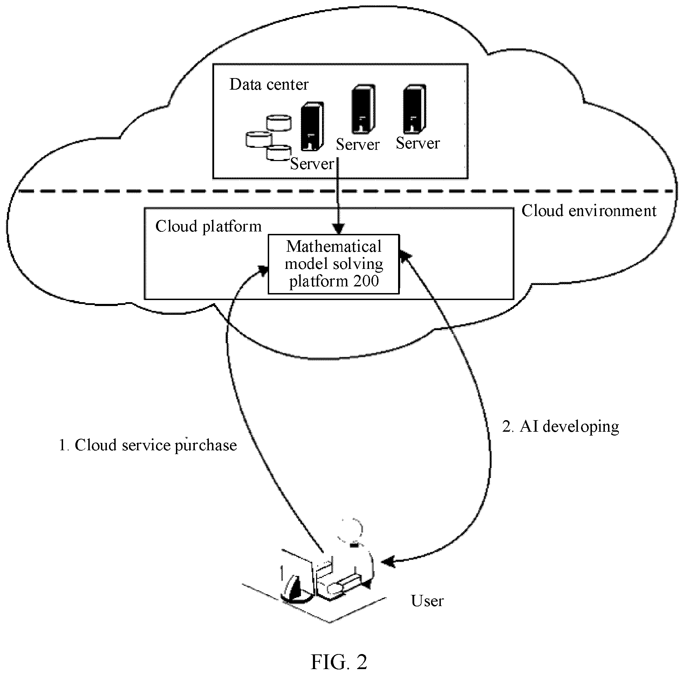

For example, FIG. 2 shows a diagram of a form of interaction between a user and a mathematical model solving platform according to an embodiment of this application. In FIG. 2, the mathematical model solving platform is mainly configured to provide functions such as mathematical modeling and problem solving. As shown in FIG. 2, the form of interaction between the user and the mathematical model solving platform 200 mainly includes: The user logs in to a cloud platform through a client web page, and selects and purchases a cloud service of the mathematical model solving platform 200 on the cloud platform. After the purchase, the user may perform mathematical modeling and problem solving based on a function provided by the mathematical model solving platform 200. When performing mathematical modeling and problem solving on the mathematical model solving platform 200, the user performs mathematical modeling and problem solving based on a basic resource (which is mainly a computing resource, such as a CPU, a GPU, or an NPU) in a data center of a cloud service provider. Therefore, during purchase and use of the mathematical model solving platform 200, what is mainly paid for is the used resource. When using the mathematical model solving platform 200, the user enters, through an interface or a command line associated with the platform, a problem description including a decision variable, a constraint, an objective function, and the like. The mathematical model solving platform 200 may automatically perform mathematical modeling and problem solving, and after the problem solving is completed, output a value of each decision variable solved by the mathematical model solving platform 200 to the user, for example, display a value of each decision variable on the interface associated with the platform. In this way, the user can obtain a corresponding decision.

In some embodiments, the mathematical model solving platform 200 shown in FIG. 2 may be independently deployed on a server or a virtual machine in a data center in a cloud environment. Alternatively, the mathematical model solving platform 200 may be deployed on a plurality of servers in the data center in a distributed manner, or deployed on a plurality of virtual machines in the data center in a distributed manner. In another embodiment, the mathematical model solving platform 200 provided in embodiments of this application may be alternatively deployed in different environments in a distributed manner. The mathematical model solving platform 200 provided in embodiments of this application may be logically divided into a plurality of parts, and each part has a different function. For example, a part of the mathematical model solving platform 200 may be deployed in a computing device in an edge environment (which is also referred to as an edge computing device), and another part may be deployed in a device in a cloud environment. The edge environment is an environment that is relatively close to a terminal computing device of the user geographically. The edge environment includes an edge computing device, for example, an edge server or an edge small cell having a computing capability. The parts of the mathematical model solving platform 200 deployed in different environments or devices collaborate to provide functions such as mathematical modeling and problem solving for the user.

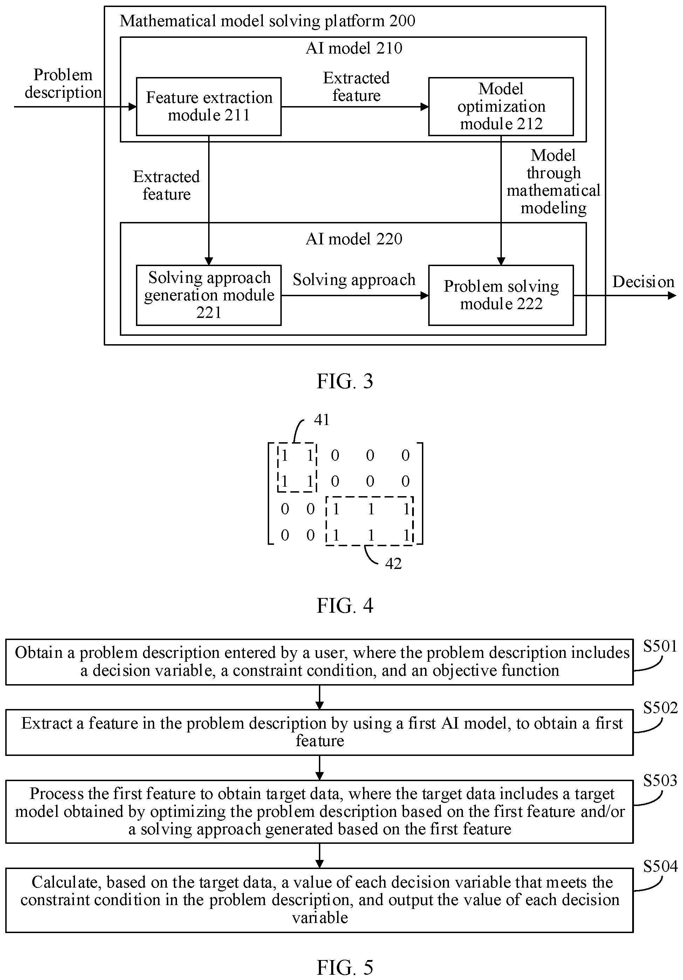

For example, FIG. 3 shows an architecture of a mathematical model solving platform. As shown in FIG. 3, the mathematical model solving platform 200 may include an AI model 210 and an AI model 220. Both the AI model 210 and the AI model 220 may be a neural network model, a decision tree (decision tree) model, or the like. The AI model 210 and the AI model 220 may be separately arranged, or may be integrated together. This may be specifically determined according to an actual situation, and is not limited herein.

The AI model 210 may include a feature extraction module 211 and a model optimization module 212. The feature extraction module 211 may be configured to perform feature extraction on a problem description entered by a user through an interface, a command line, or the like, to obtain a feature of the problem description. The feature of the problem description may be used to optimize the problem description entered by the user, and/or may be used to generate a solving approach needed for subsequent calculation.

For example, the problem description entered by the user may be but is not limited to the following:

$$\max(\min) \ Z = \sum_{j=1}^{n} c_j x_j,$$

$$s.t. \sum_{j=1}^{n} a_{ij} x_j = b_i \ (i = 1,2,\dots,m)$$

$$x_j \geq 0 (j = 1,2,\dots,n)$$

$\max(\min) \ Z = \sum_{j=1}^{n} c_j x_j$ is an objective function, $\sum_{j=1}^{n} a_{ij} x_j = b_i \ (i = 1,2,\dots,m), x_j \geq 0 (j = 1,2,\dots,n)$ is a constraint, $x_j$ is a decision variable, $c_j$ is a coefficient of the decision variable, and $b_i$ is a value of a constant term corresponding to each constraint. It may be understood that the objective function, the constraint, and the decision variable in the foregoing problem description may also be replaced with another objective function, another constraint, and another decision variable. Specifically, the objective function, the constraint, and the decision variable may be set by the user according to a decision needed by the user, and this is not limited herein. In addition, the problem description may further include a coefficient of the decision variable, a value of a constant term corresponding to each constraint, and the like. The data may be referred to as but is not limited to service data.

The problem description entered by the user may also be described in a form of a matrix. Details are as follows:

$$\max(\min) \ Z = CX$$

$$AX = b$$

$$X \geq 0.$$

A may be understood as a coefficient matrix associated with the constraint in the problem description, and b may be understood as a vector formed by the value of the constant term corresponding to each constraint.

In this embodiment, the extracted feature of the problem description may include at least one of a semantic feature, a structure feature, and a data feature. The semantic feature represents at least one of a name of each decision variable (for example, a quantity of customers or a quantity of factories), a name of each constraint (for example, a manpower upper limit or minimum investment), and a name of the objective function (for example, profit maximization or shortest time) in the problem description entered by the user, and a name of a problem (for example, a transportation problem, a human resource management problem, or a path planning problem) expressed in the problem description. The structure feature represents at least one of a structure of the coefficient matrix associated with the constraint, a distribution rule of a non-zero element in the coefficient matrix, and a type of each constraint. The data feature represents at least one of a value of each element in the coefficient matrix and the value of the constant term corresponding to each constraint.

In some embodiments, the problem description entered by the user may further include a solving preference of the user. In this case, the extracted feature of the problem description may include a user preference feature, and the user preference feature mainly represents a requirement of the user for solving, for example, a requirement for an optimal solution or a requirement for a feasible solution. In addition, the problem description entered by the user may further include background information of a problem that the user needs to solve. In this case, the extracted feature of the problem description may include a problem background feature, and the problem background feature may represent a field or an industry to which the problem that the user needs to solve belongs.

The model optimization module 212 is mainly configured to optimize, based on the feature of the problem description extracted by the feature extraction module 211, the problem description entered by the user, to obtain a standard model file (that is, a model file in a standard format). The standard model file may be read subsequently according to the solving approach, to calculate a decision. The standard model file may be understood as an optimized model. For example, a format of the standard model file may be an MPS format, an LP format, an NL format, or the like. For example, the model optimization module 212 may optimize, based on the feature extracted by the feature extraction module 211, a quantity and/or an expression form of at least one of the decision variable, the constraint, and the objective function in the problem description entered by the user, for example, identify and delete a redundant variable or constraint, add an additional auxiliary variable or constraint, modify types of the variable and constraint, decompose and regroup the coefficient matrix, or perform equivalent transformation on the coefficient matrix. In some embodiments, when the model optimization module 212 optimizes the problem description entered by the user, the mathematical model solving platform 200 may first process, by using a modeling tool, the problem description entered by the user, for example, perform preliminary model decomposition and reconstruction, to obtain an initial model; and then optimize the initial model by using the model optimization module 212, to obtain the standard model file.

For example, the model optimization module 212 may select, from a preset model library based on the semantic feature, at least one model used to describe the problem expressed by the problem description entered by the user, and combine the selected model, to complete optimization of the problem description entered by the user. It should be understood that a same problem may have a plurality of different description manners, and an optimal one of these description manners facilitates subsequent solving. In this embodiment of this application, the semantic feature is used to perform selection, to select the optimal description manner. In addition, one problem may include a plurality of sub-problems, and a same sub-problem may also have a plurality of different description manners. Therefore, in a selection process, an optimal description manner may be selected for each sub-problem, and finally, selected description manners may be combined, to complete optimization of the problem description entered by the user. The selected optimal description manner may be understood as a model. Optimizing, based on the semantic feature, the problem description entered by the user may be understood as replacing the problem expressed by the problem description or a part of the problem expressed by the problem description with an equivalent description manner.

In addition, the model optimization module 212 may determine, based on the structure feature, a substructure of the coefficient matrix included in the problem description entered by the user. Then, a model adapted to each substructure is selected from the preset model library based on the determined substructure, and selected models are combined, to complete optimization of the problem description entered by the user. It should be understood that each substructure has a plurality of different description manners, and an optimal one of these description manners facilitates subsequent solving. In this embodiment of this application, the structure feature is used to perform selection, to select the optimal description manner for each substructure in the coefficient matrix. Finally, selected description manners may be combined, to complete optimization of the problem description entered by the user. The selected optimal description manner may be understood as a model. For a substructure of the coefficient matrix, as shown in FIG. 4, content included in an area 41 may be understood as a substructure, and content included in an area 42 may be understood as another substructure. Optimizing, based on the structure feature, the problem description entered by the user may be understood as replacing the problem expressed by the problem description or a part of the problem expressed by the problem description with an equivalent description manner.

In addition, the model optimization module 212 may determine a ratio between different elements in the coefficient matrix based on the data feature. Then, a type of the coefficient matrix is determined based on the determined ratio. Finally, a model that matches the type of the coefficient matrix may be selected from the preset model library based on the type of the coefficient matrix, to complete optimization of the problem description entered by the user. It should be understood that each type of coefficient matrix has a plurality of different description manners, and an optimal one of these description manners facilitates subsequent solving. In this embodiment of this application, the data feature is used to perform selection, to select the optimal description manner for a type of a coefficient matrix, so as to complete optimization of the problem description entered by the user. The selected optimal description manner may be understood as a model. Optimizing, based on the data feature, the problem description entered by the user may be understood as replacing the problem expressed by the problem description or a part of the problem expressed by the problem description with an equivalent description manner.

It may be understood that, manners of optimizing, based on the semantic feature, the structure feature, and the data feature, the problem description entered by the user may be selected for use individually or in combination. This may be specifically determined according to an actual situation, and is not limited herein. During combination use, selected models are combined to complete optimization of the problem description entered by the user.

In this embodiment, a quantity and/or an expression form of a decision variable, a constraint, or an objective function in a model optimized by the model optimization module 212 may change. For example, the constraint in the optimized model may be increased or decreased, a coefficient of the decision variable may also change, and the objective function may also be replaced with another equivalent function.

The AI model 220 may include a solving approach generation module 221 and a problem solving module 222. The solving approach generation module 221 may be configured to: select N (N≥1) algorithms from an algorithm library based on the feature of the problem description extracted by the feature extraction module 211 in the AI model 210, and orchestrate an execution sequence and/or a calling relationship of the N algorithms, to generate a solving approach. In some embodiments, a set of all algorithms that can be used to solve a current problem may be obtained from an existing algorithm database based on a problem feature extracted in a preceding step. Then, the algorithms are further classified into sub-algorithm sets such as a pre-processing algorithm set, a heuristic algorithm set, a precise algorithm set, and a post-processing algorithm set according to algorithm features. Then, algorithms in each sub-algorithm set may be sorted based on user solving preference information and algorithm types, and an algorithm with a highest priority is selected. Finally, the selected algorithm is orchestrated to form a complete solving approach.

The problem solving module 222 reads, mainly according to the solving approach generated by the solving approach generation module 221, the model obtained through optimization by the model optimization module 212 in the AI model 210, to perform solving calculation, and outputs a value of each decision variable obtained through calculation, that is, outputs a decision. In some embodiments, after the model optimization module 212 optimizes the quantity of decision variables, during solving calculation, some post-processing algorithms may be added for processing, to calculate a value of each decision variable needed by the user.

In some embodiments, the AI model 220 in the mathematical model solving platform 200 shown in FIG. 3 may alternatively be replaced with a solver. In this case, the optimized model output by the AI model 210 may be input to the solver, and the solver performs solving, to obtain a value of each decision variable. The solver is software for solving a mathematical programming problem, and is widely used in fields such as cloud computing, finance, transportation, manufacturing, and energy.

In some embodiments, the AI model 210 in the mathematical model solving platform 200 shown in FIG. 3 may alternatively not include the model optimization module 212. In this case, the mathematical model solving platform 200 may process, by using a modeling tool, the problem description entered by the user, to obtain an initial model. When performing solving calculation, the problem solving module 222 may read, for calculation according to the solving approach generated by the solving approach generation module 221, the initial model obtained through processing by the modeling tool, to obtain a value of each decision variable. The modeling tool is a general term of software, a tool, or a system that assists in encoding and generates a mathematical optimization model. The modeling tool can identify and process objects such as a decision variable, a constraint, and an objective function, generate a coefficient matrix based on input data, and output a complete mathematical optimization problem in a standard format widely accepted in the industry. Common standard formats include .mps, .lp, and .nl.

In some embodiments, after the problem solving module 222 in the AI model 220 outputs the decision, the AI model 220 may further record duration for this solving, quality of the obtained solution, and the like, and store a mapping relationship between the data and the algorithm used in the solving process. In this way, an algorithm library used by the AI model 220 can be updated, so that an algorithm adapted to another problem can be selected during subsequent solving of the another problem.

Similarly, after the problem solving module 222 in the AI model 220 outputs the decision, the AI model 210 may further store a mapping relationship between data such as duration for this solving and quality of the obtained solution and the model used in the solving process. In this way, the model library, a feature library, and/or the like used by the AI model 210 can be updated, so that during subsequent solving of another problem, a model adapted to the another problem can be selected, or a feature with relatively high accuracy can be extracted.

In some embodiments, the feature extraction module 211 in the AI model 210 may be understood as a sub-model in the AI model 210. The model optimization module 212 in the AI model 210 may also be understood as a sub-model in the AI model 210.

The solving approach generation module 221 in the AI model 220 may be understood as a sub-model in the AI model 220. The problem solving module 222 in the AI model 220 may also be understood as a sub-model in the AI model 220.

The foregoing describes the mathematical model solving platform according to embodiments of this application. The following describes, based on the foregoing content, the mathematical model solving method according to embodiments of this application. For some or all content of the mathematical model solving method described below, refer to the foregoing related descriptions of the mathematical model solving platform.

For example, FIG. 5 shows a procedure of the mathematical model solving method. It may be understood that the method may be performed by any apparatus, device, platform, or device cluster that has computing and processing capabilities. For example, the method may be applied to a computing device or a computing device cluster. As shown in FIG. 5, the mathematical model solving method may include the following steps.

S501: Obtain a problem description entered by a user, where the problem description includes a decision variable, a constraint, and an objective function.

In this embodiment, the user may enter the problem description through an interface, a command line, or the like. After the user completes entering of the problem description, the problem description can be obtained. In some embodiments, the problem description includes the decision variable, the constraint, and the objective function. For example, the problem description may be, but is not limited to, the problem description described in FIG. 3.

S502: Extract a feature in the problem description by using a first AI model, to obtain a first feature.

In this embodiment, after the problem description is obtained, a feature in the problem description may be extracted by using the first AI model, to obtain the first feature. The first AI model may be a neural network model or a decision tree model. For example, the first AI model may be but is not limited to the feature extraction module 211 in the AI model 210 described in FIG. 3. In addition, the first feature may also be, but is not limited to, the feature extracted by the feature extraction module 211 described in FIG. 3.

S503: Process the first feature to obtain target data, where the target data includes a target model obtained by optimizing the problem description based on the first feature and/or a solving approach generated based on the first feature.

In this embodiment, after the first feature is obtained, the first feature may be processed to obtain the target data. The target data includes the target model obtained by optimizing the problem description based on the first feature and/or the solving approach generated based on the first feature.

In some embodiments, the first feature may be processed by using a second AI model, to obtain the target model. The second AI model may be but is not limited to the model optimization module 212 in the AI model 210 described in FIG. 3. In this case, the second AI model may optimize the problem description based on the first feature, for example, optimize a quantity and/or an expression form of at least one of the decision variable, the constraint, and the objective function in the problem description, to obtain a standard model file, that is, to obtain the target model. For example, a modeling tool may be first used to process the problem description, for example, perform preliminary model decomposition and reconstruction, to obtain an initial model, and then optimize the initial model by using the second AI model, to obtain the target model. For details, refer to the foregoing descriptions, and details are not described herein again.

In some embodiments, the first feature may be processed by using a third AI model, to obtain the solving approach. The third AI model may be but is not limited to the solving approach generation module 221 in the AI model 220 described in FIG. 3. In this case, the third AI model may generate the solving approach based on the first feature. For example, the third AI model may select N algorithms from an algorithm library based on the first feature, where N≥1, and orchestrate an execution sequence and/or a calling relationship of the N algorithms, to obtain the solving approach. For details, refer to the foregoing descriptions, and details are not described herein again.

S504: Calculate, based on the target data, a value of each decision variable that meets the constraint in the problem description, and output the value of each decision variable.

In this embodiment, after the target data is obtained, the value of each decision variable that meets the constraint in the problem description may be calculated based on the target data, and the value of each decision variable may be output.

In some embodiments, when the target data is the target model, the target model may be input into a preset solver, to process the target model by using the preset solver, to obtain the value of each decision variable.

In some other embodiments, when the target data is the solving approach, the modeling tool may be first used to process the problem description, to obtain an original model. Then, the original model is read for calculation according to the solving approach, to obtain the value of each decision variable.

In some other embodiments, when the target data is the target model and the solving approach, the target model may be read for calculation according to the solving approach, to obtain the value of each decision variable.

In this way, during mathematical model solving, after the user provides the problem description, a corresponding decision can be obtained, thereby reducing dependence on user experience in a mathematical modeling step and a problem solving step, and improving efficiency and generalization of mathematical modeling and problem solving.

In some embodiments, after the mathematical model solving or some steps in the mathematical model solving are completed, at least one of the first AI model, the second AI model, and the third AI model may be further updated based on problem descriptions entered by different users. For example, an algorithm library, a model library, a feature library, or the like in a model may be updated based on duration for each solving, quality of a solution obtained through calculation, or the like. In this way, accuracy of extracting a feature of a problem description each time is improved, accuracy of model optimization is improved, or efficiency of a solving approach is improved.

Based on the method in the foregoing embodiments, an embodiment of this application further provides a mathematical model solving apparatus.

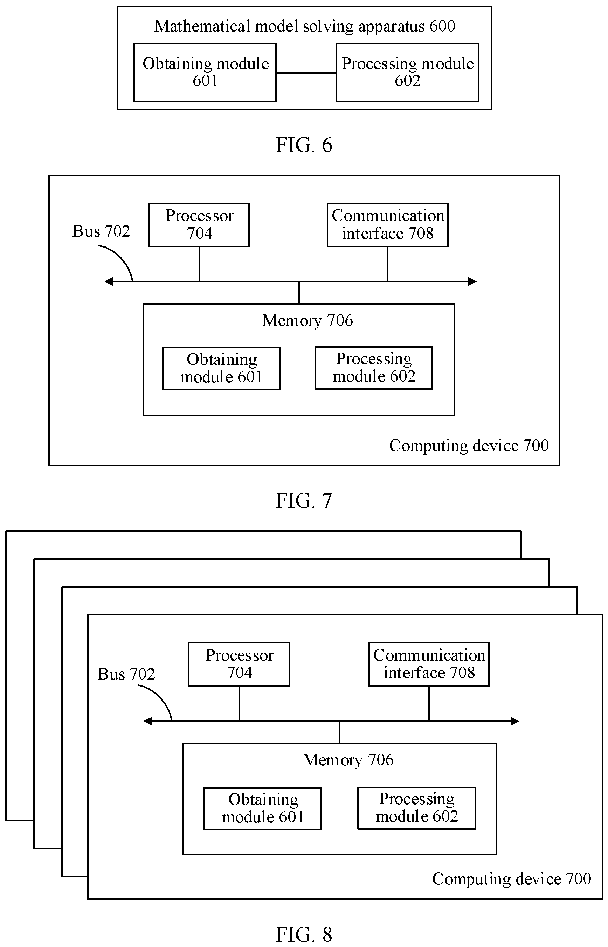

For example, FIG. 6 shows a structure of a mathematical model solving apparatus. It may be understood that the apparatus may be deployed in, but is not limited to, a computing device or a computing device cluster. As shown in FIG. 6, the mathematical model solving apparatus 600 may include an obtaining module 601 and a processing module 602. The obtaining module 601 is configured to obtain a problem description entered by a user, where the problem description includes a decision variable, a constraint, and an objective function. The processing module 602 is configured to extract a feature in the problem description by using a first artificial intelligence AI model, to obtain a first feature. The processing module 602 is further configured to process the first feature to obtain target data, where the target data includes a target model obtained by optimizing the problem description based on the first feature and/or a solving approach generated based on the first feature. The processing module 602 is further configured to: calculate, based on the target data, a value of each decision variable that meets the constraint in the problem description, and output the value of each decision variable.

In some embodiments, the target data may be the target model. When calculating, based on the target data, the value of each decision variable that meets the constraint in the problem description, the processing module 602 is specifically configured to input the target model into a preset solver, to obtain the value of each decision variable.

In some embodiments, the target data may be the solving approach. When calculating, based on the target data, the value of each decision variable that meets the constraint in the problem description, the processing module 602 is specifically configured to: read, for calculation according to the solving approach, an original model obtained by processing the problem description by using a modeling tool, to obtain the value of each decision variable.

In some embodiments, the target data may be the target model and the solving approach. When calculating, based on the target data, the value of each decision variable that meets the constraint in the problem description, the processing module 602 is specifically configured to read the target model for calculation according to the solving approach, to obtain the value of each decision variable.

In some embodiments, when processing the first feature to obtain the target data, the processing module 602 is specifically configured to optimize a quantity and/or an expression form of at least one of the decision variable, the constraint, and the objective function in the problem description by using a second AI model and the first feature, to obtain the target model; and/or select N algorithms from an algorithm library by using a third AI model and the first feature, where $N \geq 1$, and orchestrate an execution sequence and/or a calling relationship of the N algorithms, to obtain the solving approach.

In some embodiments, the processing module 602 is further configured to update at least one of the first AI model, the second AI model, and the third AI model based on problem descriptions entered by different users.

In some embodiments, the first feature includes at least one of a semantic feature, a structure feature, and a data feature. The semantic feature represents at least one of a name of each decision variable, a name of each constraint, a name of the objective function, and a name of a problem expressed by the problem description. The structure feature represents at least one of a structure of the coefficient matrix associated with the constraint, a distribution rule of a non-zero element in the coefficient matrix, and a type of each constraint. The data feature represents at least one of a value of each element in the coefficient matrix and a value of a constant term corresponding to each constraint.

In some embodiments, the problem description further includes a solving preference of the user, the first feature includes a user preference feature, and the user preference feature represents a requirement of the user for solving; and/or, the problem description further includes background information of a problem that the user needs to solve, the first feature includes a problem background feature, and the problem background feature represents a field or an industry to which the problem that the user needs to solve belongs.

It may be understood that, in this embodiment, both the obtaining module 601 and the processing module 602 may be implemented by software, or may be implemented by hardware. For example, the following uses the obtaining module 601 as an example to describe an implementation of the obtaining module 601. Similarly, for an implementation of the processing module 602, refer to the implementation of the obtaining module 601.

The module is as an example of a software functional unit, and the obtaining module 601 may include code run on a computing instance. The computing instance may include at least one of a physical host (computing device), a virtual machine, and a container. Further, there may be one or more computing instances. For example, the obtaining module 601 may include code run on a plurality of hosts/virtual machines/containers. It should be noted that the plurality of hosts/virtual machines/containers configured to run the code may be distributed in a same region (region), or may be distributed in different regions. Further, the plurality of hosts/virtual machines/containers configured to run the code may be distributed in a same availability zone (availability zone, AZ), or may be distributed in different AZs. Each AZ includes one data center or a plurality of data centers that are geographically close to each other. Generally, one region may include a plurality of AZs.

Similarly, the plurality of hosts/virtual machines/containers configured to run the code may be distributed in a same virtual private cloud (virtual private cloud, VPC), or may be distributed in a plurality of VPCs. Generally, one VPC is set in one region. A communication gateway needs to be set in each VPC for communication between two VPCs in a same region or between VPCs in different regions. Interconnection between VPCs is implemented through the communication gateway.

The module is as an example of a hardware functional unit, and the obtaining module 601 may include at least one computing device like a server. Alternatively, the obtaining module 601 may be a device implemented by using an application-specific integrated circuit (application-specific integrated circuit, ASIC) or a programmable logic device (programmable logic device, PLD), or the like. The PLD may be a complex programmable logical device (complex programmable logical device, CPLD), a field-programmable gate array (field-programmable gate array, FPGA), a generic array logic (generic array logic, GAL), or any combination thereof.

The plurality of computing devices included in the obtaining module 601 may be distributed in a same region, or may be distributed in different regions. The plurality of computing devices included in the obtaining module 601 may be distributed in a same AZ, or may be distributed in different AZs. Similarly, the plurality of computing devices included in the obtaining module 601 may be distributed in a same VPC, or may be distributed in a plurality of VPCs. The plurality of computing devices may be any combination of computing devices such as a server, an ASIC, a PLD, a CPLD, an FPGA, and a GAL.

It should be noted that, in another embodiment, the obtaining module 601 may be configured to perform any step in the method shown in FIG. 5, and the processing module 602 may also be configured to perform any step in the method shown in FIG. 5. In addition, steps implemented by the obtaining module 601 and the processing module 602 may be specified according to a requirement. The obtaining module 601 and the processing module 602 separately implement a different step in the method shown in FIG. 5, to implement all functions of the mathematical model solving apparatus.

Based on the method in the foregoing embodiment, this application further provides a computing device. For example, as shown in FIG. 7, the computing device 700 includes a bus 702, a processor 704, a memory 706, and a communication interface 708. The processor 704, the memory 706, and the communication interface 708 communicate with each other through the bus 702. The computing device 700 may be a server or a terminal device. It should be understood that quantities of processors and memories of the computing device 700 are not limited in embodiments of this application.

The bus 702 may be a peripheral component interconnect (peripheral component interconnect, PCI) bus, an extended industry standard architecture (extended industry standard architecture, EISA) bus, or the like. The bus may be classified into an address bus, a data bus, a control bus, and the like. For ease of representation, only one line is used for representation in FIG. 7, but this does not mean that there is only one bus or only one type of bus. The bus 702 may include a path for information transmission between components (for example, the memory 706, the processor 704, and the communication interface 708) of the computing device 700.

The processor 704 may include any one or more of processors such as a central processing unit (central processing unit, CPU), a graphics processing unit (graphics processing unit, GPU), a microprocessor (microprocessor, MP), and a digital signal processor (digital signal processor, DSP).

The memory 706 may include a volatile memory (volatile memory), for example, a random access memory (random access memory, RAM). The processor 704 may further include a non-volatile memory (non-volatile memory), for example, a read-only memory (read-only memory, ROM), a flash memory, a hard disk drive (hard disk drive, HDD), or a solid state drive (solid state drive, SSD).

The memory 706 stores executable program code, and the processor 704 executes the executable program code to separately implement functions of the mathematical model solving apparatus 600, so as to implement the method described in FIG. 5. In other words, the memory 706 stores instructions used to perform the method described in FIG. 5.

Alternatively, the memory 706 stores executable code, and the processor 704 executes the executable code to separately implement functions of the mathematical model solving apparatus 600, so as to implement the method described in FIG. 5. In other words, the memory 706 stores instructions used to perform the method described in FIG. 5.

The communication interface 708 uses a transceiver module, for example, but not limited to, a network interface card or a transceiver, to implement communication between the computing device 700 and another device or a communication network.

Based on the method in the foregoing embodiment, an embodiment of this application further provides a computing device cluster. The computing device cluster includes at least one computing device. The computing device may be a server, for example, a central server, an edge server, or a local server in a local data center. In some embodiments, the computing device may alternatively be a terminal device, for example, a desktop computer, a notebook computer, or a smartphone.

As shown in FIG. 8, the computing device cluster includes at least one computing device 700. A memory 706 in one or more computing devices 700 in the computing device cluster may store same instructions used to perform the method described in FIG. 5.

In some possible implementations, the memory 706 in the one or more computing devices 700 in the computing device cluster may also separately store some instructions used to perform the method described in FIG. 5. In other words, a combination of the one or more computing devices 700 may jointly execute the instructions used to perform the method described in FIG. 5.

It should be noted that memories 706 of different computing devices 700 in the computing device cluster may store different instructions to separately perform some functions of the mathematical model solving apparatus 600. In other words, instructions stored in the memories 706 in different computing devices 700 may implement functions of one or more modules in the mathematical model solving apparatus 600.

In some possible implementations, the one or more computing devices in the computing device cluster may be connected through a network. The network may be a wide area network, a local area network, or the like.

Based on the method in the foregoing embodiments, an embodiment of this application provides a computer-readable storage medium. The computer-readable storage medium stores a computer program. When the computer program is run on a processor, the processor is enabled to perform method in the foregoing embodiments.

Based on the method in the foregoing embodiments, an embodiment of this application provides a computer program product. When the computer program product runs on a processor, the processor is enabled to perform the method in the foregoing embodiments.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA), another programmable logic device, a transistor logic device, a hardware component, or any combination thereof. The general-purpose processor may be a microprocessor or any regular processor or the like.

The method steps in embodiments of this application may be implemented in a hardware manner, or may be implemented in a manner of executing software instructions by the processor. The software instructions may include corresponding software modules. The software modules may be stored in a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC.

All or some of the foregoing embodiments may be implemented by using software, hardware, firmware, or any combination thereof. When software is used to implement embodiments, all or a part of the embodiments may be implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or other programmable apparatuses. The computer instructions may be stored in a computer-readable storage medium, or may be transmitted through the computer-readable storage medium. The computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state drive (solid state drive, SSD)), or the like.

It can be understood that various numbers in embodiments of this application are merely used for differentiation for ease of description, and are not intended to limit the scope of embodiments of this application.

**Claims**

1. A mathematical model solving method, applied to a computing device or a computing device cluster, wherein the method comprises:

   Obtaining a problem description entered by a user, wherein the problem description comprises a decision variable, a constraint, and an objective function;
   extracting a feature in the problem description by using a first artificial intelligence AI model, to obtain a first feature;
   processing the first feature to obtain target data, wherein the target data comprises a target model obtained by optimizing the problem description based on the first feature and/or a solving approach generated based on the first feature; and
   calculating, based on the target data, a value of each decision variable that meets the constraint in the problem description, and outputting the value of each decision variable.

2. The method according to claim 1, wherein the problem description further comprises a solving preference of the user, the first feature comprises a user preference feature, and the user preference feature represents a requirement of the user for solving; and/or
   the problem description further comprises background information of a problem that the user needs to solve, the first feature comprises a problem background feature, and the problem background feature represents a field or an industry to which the problem that the user needs to solve belongs.

3. The method according to claim 1 or 2, wherein the processing the first feature to obtain target data specifically comprises:

   optimizing a quantity and/or an expression form of at least one of the decision variable, the constraint, and the objective function in the problem description by using a second AI model and the first feature, to obtain the target model; and/or selecting N algorithms from an algorithm library by using the third AI model and the first feature, wherein N≥1, and orchestrating an execution sequence and/or a calling relationship of the N algorithms, to obtain the solving approach.

4. The method according to claim 3, wherein the method further comprises:
   updating at least one of the first AI model, the second AI model, and the third AI model based on problem descriptions entered by different users.

5. The method according to any one of claims 1 to 4, wherein the first feature comprises at least one of a semantic feature, a structure feature, and a data feature;

   the semantic feature represents at least one of a name of each decision variable, a name of each constraint, a name of the objective function, and a name of a problem expressed by the problem description;
   the structure feature represents at least one of a structure of a coefficient matrix associated with the constraint, a distribution rule of a non-zero element in the coefficient matrix, and a type of each constraint; and
   the data feature represents at least one of a value of each element in the coefficient matrix and a value of a constant term corresponding to each constraint.

6. The method according to any one of claims 1 to 5, wherein the target data is the target model; and
   the calculating, based on the target data, a value of each decision variable that meets the constraint in the problem description specifically comprises:
   inputting the target model into a preset solver, to obtain the value of each decision variable.

7. The method according to any one of claims 1 to 5, wherein the target data is the solving approach; and
   the calculating, based on the target data, a value of each decision variable that meets the constraint in the problem description specifically comprises:
   reading, for calculation according to the solving approach, an original model obtained by processing the problem description by using a modeling tool, to obtain the value of each decision variable.

8. The method according to any one of claims 1 to 5, wherein the target data is the target model and the solving approach; and
   the calculating, based on the target data, a value of each decision variable that meets the constraint in the problem description specifically comprises:

reading the target model for calculation according to the solving approach, to obtain the value of each decision variable.

9. A mathematical model solving apparatus, deployed in a computing device or a computing device cluster, wherein the apparatus comprises:

an obtaining module, configured to obtain a problem description entered by a user, wherein the problem description comprises a decision variable, a constraint, and an objective function; and
a processing module, configured to extract a feature in the problem description by using a first artificial intelligence AI model, to obtain a first feature, wherein
the processing module is further configured to process the first feature to obtain target data, wherein the target data comprises a target model obtained by optimizing the problem description based on the first feature and/or a solving approach generated based on the first feature; and
the processing module is further configured to: calculate, based on the target data, a value of each decision variable that meets the constraint in the problem description, and output the value of each decision variable.

10. The apparatus according to claim 9, wherein the problem description further comprises a solving preference of the user, the first feature comprises a user preference feature, and the user preference feature represents a requirement of the user for solving; and/or
the problem description further comprises background information of a problem that the user needs to solve, the first feature comprises a problem background feature, and the problem background feature represents a field or an industry to which the problem that the user needs to solve belongs.

11. The apparatus according to claim 9 or 10, wherein when processing the first feature to obtain the target data, the processing module is specifically configured to:

optimize a quantity and/or an expression form of at least one of the decision variable, the constraint, and the objective function in the problem description by using the second AI model and the first feature, to obtain the target model; and/or
select N algorithms from an algorithm library by using the third AI model and the first feature, wherein N≥1, and orchestrate an execution sequence and/or a calling relationship of the N algorithms, to obtain the solving approach.

12. The apparatus according to claim 11, wherein the processing module is further configured to:
update at least one of the first AI model, the second AI model, and the third AI model based on problem descriptions entered by different users.

13. The apparatus according to any one of claims 9 to 12, wherein the first feature comprises at least one of a semantic feature, a structure feature, and a data feature;

the semantic feature represents at least one of a name of each decision variable, a name of each constraint, a name of the objective function, and a name of a problem expressed by the problem description;
the structure feature represents at least one of a structure of a coefficient matrix associated with the constraint, a distribution rule of a non-zero element in the coefficient matrix, and a type of each constraint; and
the data feature represents at least one of a value of each element in the coefficient matrix and a value of a constant term corresponding to each constraint.

14. The apparatus according to any one of claims 9 to 13, wherein the target data is the target model; and
when calculating, based on the target data, the value of each decision variable that meets the constraint in the problem description, the processing module is specifically configured to:
input the target model into a preset solver, to obtain the value of each decision variable.

15. The apparatus according to any one of claims 9 to 13, wherein the target data is the solving approach; and
when calculating, based on the target data, the value of each decision variable that meets the constraint in the problem description, the processing module is specifically configured to:
read, for calculation according to the solving approach, an original model obtained by processing the problem description by using a modeling tool, to obtain the value of each decision variable.

16. The apparatus according to any one of claims 9 to 13, wherein the target data is the target model and the solving approach; and
when calculating, based on the target data, the value of each decision variable that meets the constraint in the problem description, the processing module is specifically configured to:
read the target model for calculation according to the solving approach, to obtain the value of each decision variable.

**17.** A computing device, comprising:

at least one memory, configured to store a program; and
at least one processor, configured to execute the program stored in the memory, wherein
when the program stored in the memory is executed, the processor is configured to perform the method according to any one of claims 1 to 8.

**18.** A computing device cluster, comprising at least one computing device, wherein each computing device comprises a processor and a memory; and
the processor in the at least one computing device is configured to execute instructions stored in the memory in the at least one computing device, so that the computing device cluster performs the method according to any one of claims 1 to 8.

**19.** A computer-readable storage medium, wherein the computer-readable storage medium stores a computer program, and when the computer program is run on a processor, the processor is enabled to perform the method according to any one of claims 1 to 8.

**20.** A computer program product, wherein when the computer program product runs on a processor, the processor is enabled to perform the method according to any one of claims 1 to 8.

FIG. 1

FIG. 2

Mathematical model solving platform 200

AI model 210

Problem description →

Feature extraction module 211

Extracted feature →

Model optimization module 212

Extracted feature

Model through mathematical modeling

AI model 220

Solving approach generation module 221

Solving approach →

Problem solving module 222

→ Decision

FIG. 3

$$\begin{bmatrix} 1 & 1 & 0 & 0 & 0 \\ 1 & 1 & 0 & 0 & 0 \\ 0 & 0 & 1 & 1 & 1 \\ 0 & 0 & 1 & 1 & 1 \end{bmatrix}$$

41

42

FIG. 4

Obtain a problem description entered by a user, where the problem description includes a decision variable, a constraint condition, and an objective function — S501

Extract a feature in the problem description by using a first AI model, to obtain a first feature — S502

Process the first feature to obtain target data, where the target data includes a target model obtained by optimizing the problem description based on the first feature and/or a solving approach generated based on the first feature — S503

Calculate, based on the target data, a value of each decision variable that meets the constraint condition in the problem description, and output the value of each decision variable — S504

FIG. 5

Mathematical model solving apparatus 600

Obtaining module
601

Processing module
602

FIG. 6

Bus 702

Processor
704

Communication
interface 708

Memory 706

Obtaining
module 601

Processing
module 602

Computing device 700

FIG. 7

Bus 702

Processor
704

Communication
interface 708

Memory 706

Obtaining
module 601

Processing
module 602

Computing device 700

FIG. 8

## INTERNATIONAL SEARCH REPORT

| International application No. |
| --- |
| **PCT/CN2023/079613** |

**A. CLASSIFICATION OF SUBJECT MATTER**

G06N 20/00(2019.01)i;G06F 30/20(2020.01)i

According to International Patent Classification (IPC) or to both national classification and IPC

**B. FIELDS SEARCHED**

Minimum documentation searched (classification system followed by classification symbols)

IPC: G06N, G06F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 问题, 自动, 建模, 模型, 求解, 特征, 提取, 启发式, 搜索, 目标函数, 决策变量, 自变量, problem, automate, model, solve, feature, extract, heuristic, search, objective function, decision variable

**C. DOCUMENTS CONSIDERED TO BE RELEVANT**

| Category* | Citation of document, with indication, where appropriate, of the relevant passages | Relevant to claim No. |
| --- | --- | --- |
| X | CN 113887030 A (SOUTHERN UNIVERSITY OF SCIENCE AND TECHNOLOGY) 04 January 2022 (2022-01-04) abstract, description, paragraphs 81-160 and 187-191, and figures 3, 8, and 13 | 1-20 |
| A | CN 112818280 A (HUAWEI TECHNOLOGIES CO., LTD.) 18 May 2021 (2021-05-18) entire document | 1-20 |
| A | CN 102270190 A (TONGJI UNIVERSITY) 07 December 2011 (2011-12-07) entire document | 1-20 |
| A | CN 114579110 A (ALIPAY (HANGZHOU) INFORMATION TECHNOLOGY CO., LTD.) 03 June 2022 (2022-06-03) entire document | 1-20 |
| A | CN 114581220 A (ALIPAY (HANGZHOU) INFORMATION TECHNOLOGY CO., LTD.) 03 June 2022 (2022-06-03) entire document | 1-20 |
| A | US 9659253 B1 (IBM) 23 May 2017 (2017-05-23) entire document | 1-20 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **17 May 2023** | **23 May 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
|---|
| **PCT/CN2023/079613** |

| Patent document<br>cited in search report | | | Publication date<br>(day/month/year) | Patent family member(s) | Publication date<br>(day/month/year) |
|---|---|---|---|---|---|
| CN | 113887030 | A | 04 January 2022 | None | |
| CN | 112818280 | A | 18 May 2021 | None | |
| CN | 102270190 | A | 07 December 2011 | None | |
| CN | 114579110 | A | 03 June 2022 | None | |
| CN | 114581220 | A | 03 June 2022 | None | |
| US | 9659253 | B1 | 23 May 2017 | None | |

Form PCT/ISA/210 (patent family annex) (July 2022)

**REFERENCES CITED IN THE DESCRIPTION**

**Patent documents cited in the description**

- CN 202210801101
- CN 202211405539